Europäisches Patentamt

European Patent Office

Office européen des brevets

(11) Publication number: **0 354 449**

**A2**

## (12) EUROPEAN PATENT APPLICATION

(21) Application number: **89114205.1**

(22) Date of filing: **01.08.89**

(51) Int. Cl.⁴: **H01L 29/04 , H01L 29/60 , H01L 29/784 , H01L 29/812**

(30) Priority: **08.08.88 JP 197671/88**
**09.09.88 JP 225717/88**

(43) Date of publication of application:
**14.02.90 Bulletin 90/07**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**

(72) Inventor: **Iwamatsu, Seiichi c/o Seiko Epson**
**Corporation**
**3-5, Owa 3-chome**
**Suwa-shi Nagano-ken(JP)**

(74) Representative: **Blumbach Weser Bergen**
**Kramer Zwirner Hoffmann Patentanwälte**
**Radeckestrasse 43**
**D-8000 München 60(DE)**

(54) **Semiconductor single crystal substrate.**

(57) A semiconductor single crystal substrate (1) has the crystal face orientation (110) and the crystal orientation of the orientation flat (1a) <110> or the crystal face orientation (100) and the crystal orientation of the orientation flat <100>. The semiconductor single crystal substrate is provided thereon with a trench gate, a source, a drain, a trench gate electrode, a source electrode and a drain electrode.

FIG. 1

# SEMICONDUCTOR SINGLE CRYSTAL SUBSTRATE

The present invention relates to the crystal face orientation and the crystal orientation of the orientation flat in a semiconductor single crystal substrate which is used for the production of a semiconductor device.

In a conventional semiconductor single crystal substrate, mainly of Si, the crystal face orientation is generally (100) and the crystal orientation of the orientation flat is generally <110>.

The reason why the crystal orientation of the orientation flat of a conventional Si wafer is <110> is that the break of the Si wafer is easy in the case of subjecting the Si wafer to diamond scribing vertically or horizontally with respect to the orientation flat.

In the case of producing a trench gate MOS FET by using such a conventional Si wafer, however, the threshold voltage on the side wall is disadvantageously largely different from the threshold voltage at the bottom portion in the trench, namely since the side wall of the trench gate has the crystal face (110) the threshold voltage of the trench gate is higher on the crystal face (110) and lower on the bottom surface.

Accordingly, it is an object of the present invention to eliminate the above-described problems in the prior art and to provide a crystal face orientation and a crystal orientation of the orientation flat of a semiconductor single crystal substrate with which the difference between the threshold voltage on the side wall and that at the bottom portion of the trench gate portion of a trench gate MOS FET can be restricted within a narrow limit.

It is another object of the present invention to determine the orientation flat of a semiconductor single crystal substrate, so that in the production of a trench gate MOS FET the side wall of the trench also has the crystal face (100)

These objects are achieved with a semiconductor single crystal substrate as claimed.

The above and other objects, features and advantages of the present invention will become clear from the following describtion of preferred embodiments thereof, taken in conjunction with the accompanying drawings, in which:

Fig. 1 is a plan view of a silicon wafer according to an embodiment of the present invention;

Fig. 2 is a sectional view of the main part of a trench gate MOS FET, which is an example of application of the present invention;

Fig. 3 is a plan view of a silicon wafer according to an embodiment of the present invention;

Fig. 4 is a sectional view of the trench fabricated by using a silicon wafer according to the present invention; and

Fig. 5 is a sectional view of a MES FET using a GaAs substrate, which is another example of application of the present invention.

The present invention will be explained in detail with reference to embodiments.

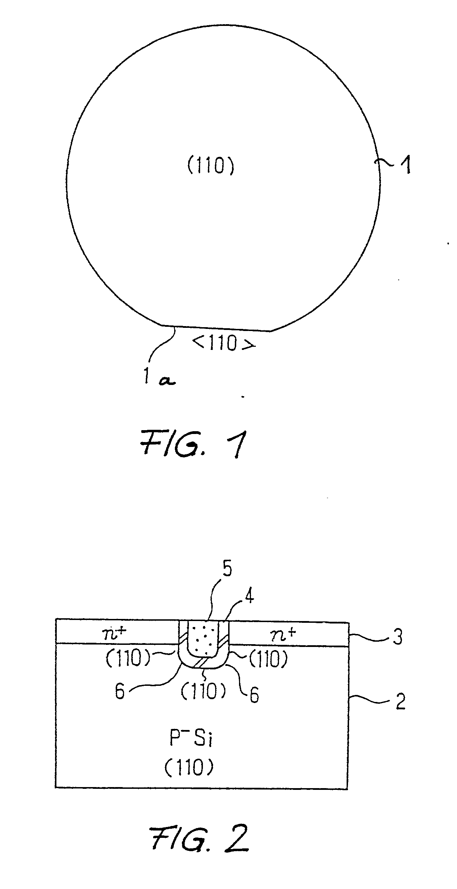

Fig.1 shows the surface of an Si wafer 1 according to an embodiment of the present invention. The Si wafer has the crystal face (110) and the crystal orientation of the orientation flat 1a is <110>.

Fig.2 is a sectional view of the main part of a trench gate MOS FET, which is an example of application of the present invention. The surface of an Si substrate 2 is provided with a diffusion layer 3 and a trench gate composed of a gate oxide film 4 and a gate electrode 5 formed in a trench. The side wall of the trench has the crystal face (110), but the bottom portion 6 has a wide range of crystal faces from (100) to (111) through (110).

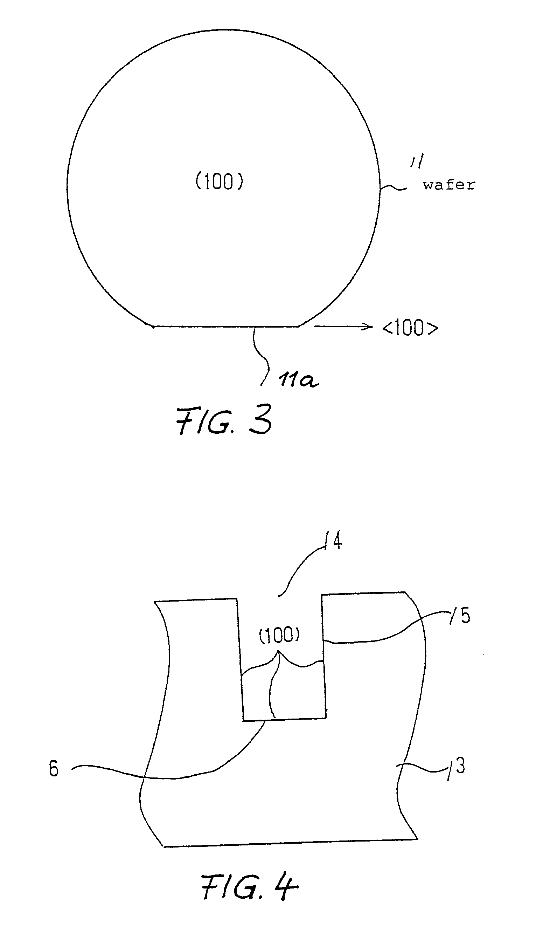

Fig.3 is a plan view of a silicon wafer according to another embodiment of the present invention, and Fig.4 is a sectional view of the trench fabricated by using a silicon wafer according to the present invention, showing the crystal surfaces in the trench.

In Fig.3, the surface of an Si wafer 11 of, e.g., 400 μm thickness and 5" diameter, has the crystal face (100), and the crystal orientation of an orientation flat 11a is <100>. The length of the orientation flat 11a which is attached to the Si wafer 11 is 10 mm.

When a trench gate MOS FET is produced by using the Si wafer 11, since the gate pattern is drawn vertically and horizontally relative to the orientation flat 11a, in the section of a trench 14 which is fabricated by dry etching the surface of the Si wafer 11, the crystal orientation of the side wall 15 is (100) and the crystal orientation of the bottom surface 16 is also (100).

When the crystal orientation of the orientation flat is <100>, the break of the wafer with a diamond scriber is difficult. This is no problem, however, because full cut dicing has recently been commonly adopted for cutting an Si wafer, by which a diamon-buried wheel called a diamond wheel is rotated at a high speed so as to thoroughly cut the Si wafer from the surface to the back face.

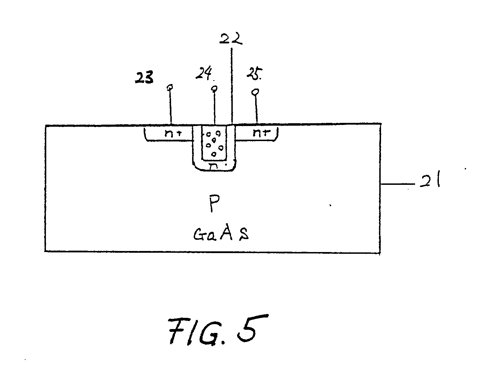

Fig.5 is a sectional view of a field effect transistor using a GaAs wafer, which is another example of application of the present invention. This transistor has a MES (Metal Electrode Semiconductor) structure. In the trench gate of a GaAs substrate 21, GaAs MBE (Molecular Beam Epitaxial) layer 22 is formed, and a gate 24 is buried in the GaAs MBE layer 22. Diffusion layers, namely, a source 23 and a drain are provided in such a manner as to sandwich the region of the gate 24 therebetween. A source electrode and a drain electrode are connected to the power source or grounded. In this example, as in the above-described example, when the crystal face orientation of the GaAs substrate is (100) and the crystal orientation of the orientation flat is <100>, the side wall of the trench has the crystal face (100), so that the threshold voltage is constant both on the side wall and on the bottom surface. When the crystal face orientation of the GaAs substrate is (110) and the crystal orientation of the orientation flat is <110>, the difference in threshold voltage of the trench gate between on the side wall and at the corner portion is effectively restricted within a narrow limit.

The crystal face orientation (110) may be slightly deviated from. The relationship between the deviation angle from the crystal face orientation (110) and the difference in threshold voltage is shown in Table 1. As is clear from Table 1, a deviation angle of 0 to 4° is in the range of the difference in threshold voltage which does not cause any practical problem.

Table 1

| Deviation angle | Difference in threshold voltage |
|---|---|
| 0 | None |
| 1 | Very small |
| 2 | Very small |
| 3 | Small |
| 4 | Small |
| 5 | Small to medium |
| 8 | Medium |
| 10 | Large |

As described above, according to the present invention, since the crystal face orientation of the semiconductor substrate is (110) and the crystal orientation of the orientation flat is <110>, it is possible to obtain a threshold voltage of the trench gate of a trench gate field effect transistor which fluctuates from the threshold voltage on the crystal face (110) within a narrow limit only.

In addition, according to the present invention, it is also possible to provide the inner wall of the trench of a trench gate FET with the crystal face (100), thereby effectively preventing an increase in threshold voltage.

**Claims**

1. A semiconductor single crystal substrate (1) in which the crystal face orientation is (110) and the crystal orientation of the orientation flat (1a) is <110>.

2. A semiconductor single crystal substrate (11) in which the crystal face orientation is (100) and the crystal orientation of the orientation flat (11a) is <100>.

3. A substrate according to claim 1 or 2, wherein said semiconductor substrate (1; 11) is a silicon single crystal wafer.

4. A substrate according to claim 1 or 2, wherein said semiconductor substrate (21) is a compound semiconductor single crystal wafer containing GaAs or InP as the main ingredient.

5. A substrate according to any of claims 1 to 4 which is provided thereon with a trench gate, a source, a drain, a trench gate electrode, a source electrode and a drain electrode.

(110)

~1

1a ⟨110⟩

# FIG. 1

5

4

n⁺          n⁺    ~3

(110)       (110)

6    (110)   6

~2

P⁻Si

(110)

# FIG. 2

(100)

*11*
wafer

→ <100>

*11a*

*FIG. 3*

*14*

(100)

*15*

6

*13*

*FIG. 4*

FIG. 5